# NOUVEAU FASCICULE DE BREVET EUROPEEN

(11) **EP 1 186 032 B2**
(45) Date de publication et mention de la décision concernant l'opposition: **14.07.2010**
(45) Mention de la délivrance du brevet: 10.12.2003
(21) Numéro de dépôt: 00925352.7
(22) Date de dépôt: 28.04.2000
(51) Int. Cl.: H01L 23/24

(54) **PROCEDE DE FABRICATION DE DISPOSITIF ELECTRONIQUE PORTABLE A CIRCUIT INTEGRE PROTEGE PAR RESINE PHOTOSENSIBLE**
HERSTELLUNGSVERFAHREN EINER TRAGBAREN ELEKTRONISCHEN ANORDNUNG MIT EINER INTEGRIERTEN SCHALTUNG, DIE DURCH EIN PHOTOEMPFINDLICHES HARZ GESCHÜTZT WIRD
METHOD FOR PRODUCING A PORTABLE ELECTRONIC DEVICE WITH AN INTEGRATED CIRCUIT PROTECTED BY A PHOTOSENSITIVE RESIN

(30) Priorité: 28.04.1999 FR 9905394
(43) Date de publication de la demande: 13.03.2002
(73) Titulaire: Gemalto SA, 92190 Meudon (FR)
(72) Inventeur: LAVIRON, Thierry, F-13790 Peynier (FR); LERICHE, Christian, F-13530 Trets (FR); FOURNIER, Jean-Pierre, F-13660 La Ciotat (FR)
(86) Numéro de dépôt international: PCT/FR2000/001149
(87) Numéro de publication internationale: WO 2000/067316

(56) Documents cités:
- EP-A- 0 470 559
- EP-A- 0 670 595
- DE-A- 19 640 304
- US-A- 5 776 798
- DATABASE WPI Section Ch, Week 199020 Derwent Publications Ltd., London, GB; Class A26, AN 1990-152398 XP002130372 "Sealing resin compsn. with low linear expansion coefft. - obtd. by compounding poly-maleimide cpd., poly:allyl cpd. and inorganic filler" -& JP 02 097561 A (MITSUBISHI PETROCHEMICAL CO LTD), 10 avril 1990 (1990-04-10)
- PATENT ABSTRACTS OF JAPAN vol. 1999, no. 09, 30 juillet 1999 (1999-07-30) -& JP 11 100489 A (SUMITOMO BAKELITE CO LTD), 13 avril 1999 (1999-04-13)
- PATENT ABSTRACTS OF JAPAN vol. 1998, no. 08, 30 juin 1998 (1998-06-30) -& JP 10 060232 A (NAGASE CHIBA KK), 3 mars 1998 (1998-03-03)
- PATENT ABSTRACTS OF JAPAN vol. 017, no. 245 (E-1365), 17 mai 1993 (1993-05-17) -& JP 04 368137 A (TOSHIBA CORP), 21 décembre 1992 (1992-12-21)
- PATENT ABSTRACTS OF JAPAN vol. 012, no. 110 (C-486), 8 avril 1988 (1988-04-08) -& JP 62 235315 A (IBIDEN CO LTD), 15 octobre 1987 (1987-10-15)

## Description

La présente demande concerne la fabrication d'un dispositif électronique portable, comportant au moins une puce de circuit intégré noyée dans un support et électriquement reliée à des éléments d'interface constitués par un bornier de connexion et/ou par une antenne.

Ces dispositifs électroniques portables constituent par exemple des cartes à puce avec et/ou sans contact ou encore des étiquettes électroniques.

Les cartes à puce avec et/ou sans contact sont destinées à la réalisation de diverses opérations telles que, par exemple, des opérations bancaires, des communications téléphoniques, diverses opérations d'identification, ou des opérations de type télébillétique.

Les cartes à contact comportent des métallisations affleurant la surface de la carte, disposées à un endroit précis du corps de carte, défini par la norme usuelle ISO 7816. Ces métallisations sont destinées à venir au contact d'une tête de lecture d'un lecteur en vue d'une transmission électrique de données.

Les cartes sans contact comportent une antenne permettant d'échanger des informations avec l'extérieur grâce à un couplage électromagnétique entre l'électronique de la carte et un appareil récepteur ou lecteur. Ce couplage peut être effectué en mode lecture ou en mode lecture/écriture, et la transmission de données s'effectue par radiofréquence ou par hyperfréquence .

Il existe également des cartes hybrides ou « combicards » qui comportent à la fois des métallisations affleurant la surface de la carte et une antenne noyée dans le corps de la carte. Ce type de carte peut donc échanger des données avec l'extérieur soit en mode contact, soit sans contact.

Telles qu'elles sont réalisées actuellement, les cartes, avec ou sans contact, sont des éléments portables de faible épaisseur et de dimensions normalisées. La norme ISO 7810 correspond à une carte de format standard de 85 mm de longueur, de 54 mm de largeur et de 0.76 mm d'épaisseur.

La majorité des procédés de fabrication de carte à puce est basée sur l'assemblage de la puce de circuit intégré dans un sous-ensemble appelé micromodule qui est encarté, c'est à dire placé dans une cavité ménagée dans le corps de carte, en utilisant des techniques connues de l'homme du métier.

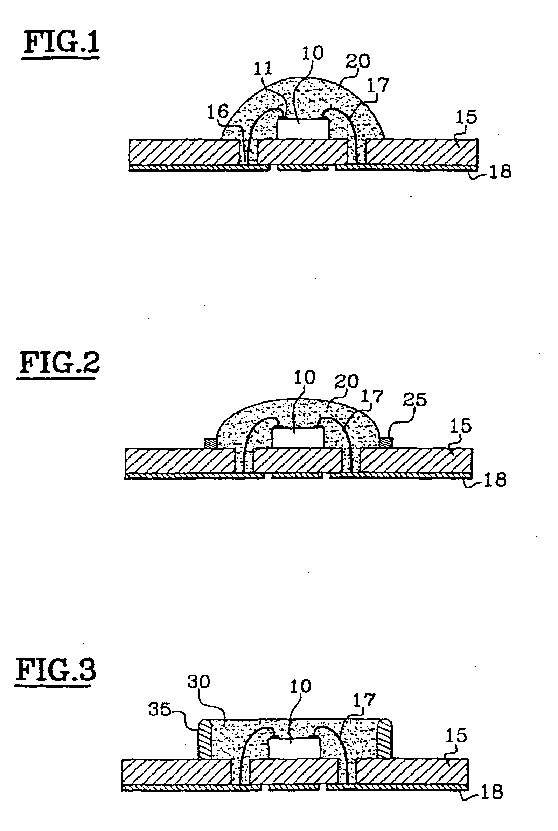

Un procédé classique de fabrication d'un micromodule avec contact est illustré sur la figure 1. Un tel procédé consiste à coller une puce de circuit intégré 10 en disposant sa face active avec ses plots de contact 12 vers le haut, et en collant sa face opposée sur une feuille de support diélectrique 15. La feuille diélectrique 15 est elle-même disposée sur une grille de contact 18 telle qu'une plaque métallique en cuivre nickelé et doré par exemple. Des puits de connexion 16 sont pratiqués dans la feuille diélectrique 15 afin de permettre à des fils de connexion 17 de relier les plots de contact 12 de la puce 10 aux plages de contact de la grille 18.

Selon certaines variantes, il est possible de coller la puce 10, face active vers le haut, directement sur la grille de contact 18, puis de la connecter par câblage filaire 17.

Dans le cas d'un micromodule sans contact une antenne, déposée sur le support diélectrique par sérigraphie ou autre, est connectée la grille métallique.

Dans une variante de réalisation, la puce peut également être collée sur un support diélectrique et connectée à des plages de connexion définies sur ledit support. Le micromodule ainsi obtenu pourra ultérieurement être connecté par soudure ou collage à une antenne filaire, gravée ou déposée par sérigraphie.

Une étape de protection ou d'encapsulation vient ensuite protéger la puce 10 et les fils de connexion 17 soudés. On utilise généralement une technique appelée « glob top » en terminologie anglaise, qui désigne l'enrobage de la puce par le dessus. Cette technique consiste à utiliser une goutte de résine 20, à base d'époxy par exemple, thermodurcissable ou à réticulation aux ultraviolets.

Généralement, on utilise une résine thermique tridimensionnelle qui nécessite une étape de polymérisation dans des conditions opératoires lourdes à mettre en oeuvre. En effet, un passage en étuve à plus de 90°C pendant une durée pouvant atteindre 24 heures est nécessaire, ce qui implique un temps de procédé rallongé, un appareillage adéquat et l'intervention d'un opérateur.

Il est également possible d'utiliser des résines polymérisables par exposition aux ultraviolets. Cependant, de telles résines sont généralement trop flexibles, ce qui entraîne des problèmes de fonctionnement électriques et de stress lorsque la puce est sollicitée en flexion.

Les résines polymérisables aux ultraviolets sont donc rarement utilisées directement comme protection selon la technique classique du « glob top ».

Le dépôt de la résine 20 sur la puce et les fils de connexion peut être effectué directement sur le film diélectrique pour des puces de petites dimensions.

Néanmoins, afin de limiter les risques de coulée de la résine sur les bords du circuit, il est avantageux de délimiter la surface d'étalement de la goutte de résine par une barrière de manière à obtenir une forme de protection reproductible.

La figure 2 illustre le dépôt d'une barrière 25 sur le film diélectrique 15. Cette barrière 25 peut être réalisée en polymère, tel que de l'époxy, du silicone ou un polyester. Elle entoure la puce 10 et peut être déposée sur le film diélectrique 15 par sérigraphie ou par un procédé de distribution.

Cette barrière 25 peut également être constituée d'un cadre de métal estampé et collé sur le film diélectrique 15 autour de la puce 10.

Selon les cas, cette barrière 25 est déposée sur le support 15 dans une étape du procédé de fabrication, ou elle peut être livrée directement par le fournisseur du support diélectrique 15.

La présence d'une barrière 25 entourant la puce 10 facilite la dépose de la résine de protection 20 mais ne permet pas forcément de s'affranchir de l'étape de fraisage indispensable lorsqu'une goutte de résine trop grosse à été déposée. En effet, la goutte de résine peut gêner l'encartage du micromodule par une surépaisseur trop importante.

Le fraisage permet d'optimiser la hauteur et la forme de la résine de protection.

Cependant, le fraisage constitue une opération stressante pour la puce connectée.

De plus, cette opération nécessite une grande précision afin de ne pas détériorer la connexion ou la face active de la puce.

En outre, le fraisage constitue une étape supplémentaire du procédé de fabrication et présente un coût non négligeable.

Un micromodule 50, constitué par la puce 10 reportée sur la bande de support diélectrique 15 et connectée à une interface de communication 18, est ensuite encarté dans la cavité d'un corps de carte préalablement décoré.

Cette opération d'encartage peut être effectuée par dépôt d'une colle liquide dans la cavité du corps de carte avant report du micromodule, ou par dépôt d'un film adhésif thermoactivable par lamination à chaud sur le film diélectrique 15 et par pressage à chaud au moyen d'une presse dont la forme est adaptée à celle de la cavité du corps de carte.

Ces procédés classiques de fabrication de micromodules présentent néanmoins de nombreux inconvénients.

D'une part, la présence d'un anneau pour circonscrire la résine de protection n'est souvent pas suffisante pour prévenir le fraisage. Il en résulte un recouvrement de la puce qui n'est pas optimisé et que la géométrie du micromodule n'est pas parfaitement maîtrisée, en particulier sur les bords de la puce. Un débordement de la résine peut entraîner la mise au rebut du micromodule.

Il est important de bien maîtriser l'épaisseur du micromodule, et donc la hauteur de la résine de protection, afin de réaliser des dispositifs à circuit intégré extra plats.

De plus, la pose ou l'achat d'un film avec une barrière, quelle qu'elle soit, et/ou le fraisage de la résine présentent un coût non négligeable.

D'autre part, l'utilisation d'une résine thermique, traditionnellement utilisée dans la technique classique de l'encapsulation, impose un temps de polymérisation trop long pour un procédé de fabrication en continu.

Le document EP-A-0 470 559 décrit un procédé de fabrication d'un dispositif électronique comprenant le dépôt d'un cordon de résine polymérisable aux ultraviolets autour de la puce de circuit intégré et de ses fils de connexion, polymérisation de cette résine aux ultraviolets, ensuite dépôt d'une résine de remplissage dans l'espace délimité par le cordon de résine et sa polymérisation aux ultraviolets.

Le but de la présente invention est de pallier aux inconvénients de l'art antérieur.

A cet effet, la présente invention propose un procédé de fabrication de carte à puce permettant d'associer une fiabilité du produit fini avec une simplicité et une réduction du nombre d'étape de fabrication.

En particulier, la présente invention propose de réaliser le dépôt d'une protection du micromodule en utilisant un procédé connu sous le nom de « DAM and FILL » en anglais qui désigne un procédé de protection de la puce de circuit intégré en deux étapes.

Dans un premier temps, un cordon de résine de forte viscosité, « DAM », est déposé autour de la puce et de ses fils de connexion.

Dans un second temps, une résine de remplissage, « FILL », recouvre la puce et ses fils dans l'espace délimité par le cordon de résine.

Selon une caractéristique essentielle de l'invention, les résines utilisées pour le cordon et pour le remplissage sont toutes deux des résines polymérisables par exposition aux ultraviolets. Les différentes étapes du procédé sont réalisées à la suite et en continu, et l'étape de polymérisation est réalisée simultanément sur les deux résines.

Selon une particularité de l'invention, les deux résines contiennent des moyens de renforcement mécanique et notamment des fibres de verre.

La présente invention a pour objet un procédé de protection d'un dispositif électronique portable à circuit intégré selon la revendication 1.

Selon une caractéristique de l'invention, au moins la résine de remplissage comporte des fibres de renfort mécanique.

Selon une particularité, les fibres de renfort sont des fibres de verre.

Avantageusement, les pourcentages de fibres de verre contenues dans les résines sont compris entre 5% et 20%.

Selon une autre caractéristique, les résines de protection sont des résines époxydes cationiques.

Selon une autre caractéristique, les résines contiennent en outre un faible pourcentage d'ions fluorures extractibles, une partie desdits ions étant neutralisée par ajout de composés chimiques de Magnésium.

Selon une particularité, les quantités d'ions fluorures contenues dans les résines sont comprises entre 20% et 40% des concentrations usuelles, ces dernières étant supérieures ou égales à 250 ppm.

Selon une autre caractéristique, les résines contiennent en outre des agents flexibilisants comprenant un ou le mélange de plusieurs alcools oligomériques.

Selon une particularité, les alcools oligomériques sont des polyesters et/ou des polycarbonates et/ou des polyethers et/ou des polybutadienes et/ou les copolymères de ces derniers.

Selon une autre caractéristique, les résines contiennent en outre un ou le mélange de plusieurs photo initiateurs.

Selon une particularité, les photo initiateurs sont des sels de triarylsulfonium.

Selon une autre caractéristique, les résines contiennent en outre des monomères et/ou oligomères polymérisables par voie cationique sous ultraviolets.

Selon une particularité, les monomères et/ou oligomères sont des époxydes cycloaliphahiques.

Le procédé selon l'invention est simple à mettre en oeuvre et simplifie les procédés antérieurs.

En particulier, les étapes de dépose d'une barrière et de fraisage sont supprimées, et le temps de polymérisation est considérablement raccourci par l'utilisation de résines à réticulation aux ultraviolets. Cela permet des gains de productivité et de prix unitaire de fabrication importants.

La dépose du cordon de résine est réalisé en temps masqué par rapport au dépôt de la résine de remplissage. Le temps global d'encapsulation de la puce et de ses fils est donc égal au temps de dépôt d'une goutte de résine dans la technique classique du « glob top ».

De plus, le procédé selon l'invention utilise des résines photosensibles malgré les préjugés généralement associés à de telles résines.

En outre, les deux résines sont polymérisées simultanément dans la continuité du procédé de fabrication, à la suite des dépôts.

Le procédé selon la présente invention permet d'atteindre des cadences de fabrication de 12000 pièces par heures en continue.

De plus, le procédé de fabrication selon l'invention présente l'avantage de maîtriser parfaitement l'épaisseur de la protection de la puce.

En outre, la protection présente une bonne étanchéité, car les deux résines se mélangent légèrement avant d'être polymérisées par simple exposition aux ultraviolets dans la continuité de la chaîne de fabrication.

La nature du cordon de résine contribue, en plus de sa fonction de limitation de l'étalement de la protection, à la protection et à la rigidité du micromodule.

Les résines utilisées dans le procédé selon l'invention permettent d'accroître la qualité et la fiabilité du dispositif électronique obtenu.

D'autres particularités et avantages de l'invention apparaîtront à la lecture de la description donnée à titre d'exemple illustratif et non limitatif et faite en référence aux figures annexées qui représentent :
- La figure 1, déjà décrite, est un schéma en coupe transversale illustrant un procédé traditionnel de fabrication de carte à puce ;
- La figure 2, déjà décrite, est un schéma en coupe transversale illustrant le dépôt d'une barrière délimitant l'étalement de la résine de protection ;
- La figure 3 est un schéma en coupe transversale du micromodule obtenu selon le procédé de la présente invention ;
- La figure 4 est un schéma synoptique des différentes étapes du procédé de fabrication selon la présente invention.
- La figure 5 est un schéma vue de dessus des étapes de protection selon le procédé de la présente invention.

En se référant à la figure 3, une puce de circuit intégré 10 est collée sur un support diélectrique 15 et connectée à une interface de communication 18 par un câblage filaire 17.

Le procédé de fabrication selon l'invention consiste à réaliser une protection du micromodule, constitué par la puce 10 et ses fils de connexion 17, en déposant deux résines différentes, en deux étapes, dans un procédé continu.

Une première résine 35 est déposée sur la périphérie du micromodule afin de constituer un cordon tout autour de la puce 10 et de ses fils 17.

Ce cordon de résine 35 est avantageusement constitué d'une résine de forte viscosité, préférentiellement supérieure ou égale à 150000 CPS.

Une seconde résine 30 est alors déposée dans l'espace délimité par le cordon de résine 35 afin de remplir cet espace est de couvrir complètement la puce 10 et ses fils de connexion 17.

Cette résine de remplissage 35 est avantageusement constituée d'une résine de faible viscosité, préférentiellement inférieure ou égale à 6000 CPS.

Les résines utilisées, pour le cordon 35 et pour le remplissage 30, présentent des propriétés chimiques spécifiquement adaptées au procédé de fabrication selon l'invention.

En particulier, au moins la résine de remplissage 30 comprend des moyens de renforcement mécanique qui peuvent se présenter sous forme de fibres et notamment de fibres de verre.

En outre, la résine constituant le cordon 35 peut avantageusement présenter cette même particularité de renforcement mécanique.

Selon un mode de réalisation préférentiel, les résines 30 et 35 sont des résines époxydes cationiques contenant un pourcentage important de fibres de verre dont le facteur de forme, c'est à dire le facteur longueur de la fibre sur son diamètre (L/d) est spécifiquement adapté à l'application voulue.

La présence de fibres de verre dans les résines 30 et 35 apporte une élasticité de la protection adaptée, un coefficient d'expansion thermique bas, un étalement contrôlé du dépôt, ainsi qu'une réduction du retrait lié à la polymérisation des résines.

Les résines 30 et 35 contiennent en outre un faible pourcentage d'ions fluorures extractibles. L'ajout de composés chimiques de Magnésium neutralise en effet une partie des fluorures qui ne sont alors plus extractibles.

On obtient un composé contenant seulement 20% à 40% des taux usuels d'ions fluorures contenus généralement dans les résines utilisées classiquement, sachant que ces taux usuels sont supérieurs ou égaux à 250 ppm. On obtient ainsi des résines avec un taux d'ions fluorures inférieur ou égal à 100 ppm.

La faible quantité de ces ions fluorures améliore les propriétés électriques des résines.

De plus, les résines 30 et 35 contiennent des agents flexibilisants peu rigides et peu durs afin d'éviter les fissurations dans la protection.

Ces agents flexibilisants sont basés sur des structures d'alcools oligomériques de type polyesters, polycarbonates, polyesthers, polybutadienes et/ou leur copolymères, par exemple.

Ces agents flexibilisants peuvent être utilisés seuls ou en mélange de plusieurs d'entre eux dans la composition des résines 30 et 35.

Des photo initiateurs sont également compris dans la composition des résines 30 et 35. Il peut d'agir, par exemple, de sels de triaylsulforium utilisés seuls ou en mélange.

Ces photo initiateurs permettent d'adapter la longueur d'onde d'absorption aux longueurs d'onde d'émission des lampes à ultraviolets utilisées pour la polymérisation des résines.

De plus, ces photo initiateurs permettent surtout de faciliter l'adhésion des résines sur le support diélectrique 15.

En effet, l'adhésion et la polymérisation des résines 30 et 35 n'est pas évidente car la réaction est neutralisée par la composition spécifique des photo initiateurs qui n'adhère pas facilement sur le diélectrique 15.

De plus, des polymères et/ou des oligomères polymérisables par voie cationique sous ultraviolets sont compris dans la composition des résines 30 et 35, et plus particulièrement des époxydes cycloaliphatiques qui sont les seules à entraîner la polymérisation sous ultraviolets.

L'ensemble des éléments constituant les résines 30 et 35 sont mélangés dans des proportions déterminées par l'homme du métier selon les applications souhaitées.

En particulier, les proportions seront différentes pour la résine de remplissage 30 et pour le cordon de résine 35.

Le cordon de résine 35 permet de réaliser une barrière afin de limiter l'étalement de la résine de protection.

En outre, le dépôt d'un cordon de résine permet de maîtriser parfaitement la hauteur et la forme de la protection du micromodule.

La résine de remplissage 30 étant de faible viscosité, elle remplie l'espace délimité par le cordon de résine 35 jusqu'au bord de ce dernier.

L'étape de fraisage est ainsi supprimée.

Préférentiellement, le cordon de résine 35 présente une hauteur supérieure ou égale à la hauteur de la puce 10 avec ses fils de connexion 17, de manière à ce que la résine de remplissage 30 englobe les fils de connexion 17.

Le procédé selon la présente invention permet d'obtenir des micromodules d'une épaisseur inférieure ou égale à 580 µm, ce qui est largement en deçà des normes ISO.

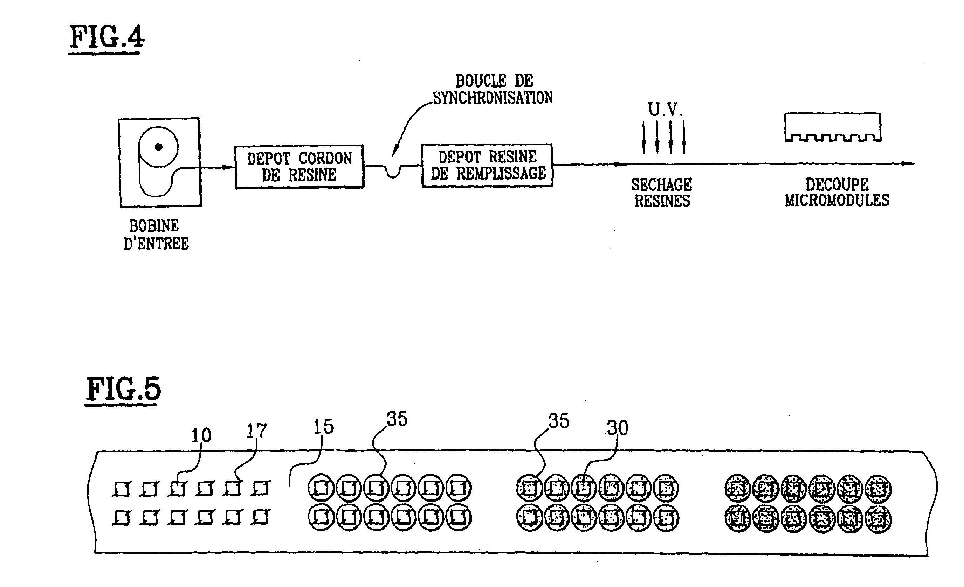

La figure 4 illustre schématiquement les étapes du procédé de fabrication selon la présente invention.

Un film support 15 sur lequel sont collées et connectées des puces de circuit intégré 10 est déroulé selon un procédé classique aux chaînes de fabrication de dispositifs électroniques.

Une première station de dépôt réalise le cordon de résine autour de chaque puce avec une première tête d'injection.

Selon un mode de réalisation préférentiel, la tête d'injection du cordon de résine est une tête programmable multivannes. En particulier, douze dépôts sont effectués simultanément avec une forme ronde, carré, ovale ou autre selon le programme choisi pour l'application souhaitée.

Une deuxième station de dépôt, située dans la continuité de la chaîne de fabrication, délivre la résine de remplissage avec une deuxième tête d'injection. Cette deuxième tête d'injection présente le même nombre de vannes que la première. Elle délivre une goutte de résine de remplissage de très faible viscosité, calibrée de manière à remplir complètement l'espace délimité par le cordon de résine.

Une boucle de synchronisation entre les deux stations de dépôt permet d'éviter toute tension sur le film support.

Selon une particularité de l'invention, le dépôt du cordon de résine est réalisé en temps masqué par rapport au dépôt de la résine de remplissage. Le temps de dépôt d'une protection sur les puces et leurs fils de connexion est donc équivalent au temps de dépôt d'une goutte de résine dans un procédé classique de « glob top ».

Le procédé selon l'invention comporte ensuite une étape de séchage des résines déposées réalisée en continu à la suite des dépôts.

Le film supportant les puces couvertes des deux résines traverse une zone d'exposition aux ultraviolets sur une distance déterminée afin de polymériser les résines.

La détermination des proportions des éléments constitutifs des résines 30 et 35 permettent un ajustement des conditions de fabrication telles que la vitesse de polymérisation qui fixe la cadence de production.

Le procédé de fabrication selon l'invention permet d'atteindre une cadence de fabrication de 12000 pièces par heure. Cette vitesse de défilement des puces sur le support est compatible avec l'équipement décrit, et la zone d'exposition aux ultraviolets n'excède pas deux mètres de long.

Les micromodules sont alors découpés avec un poinçon par exemple, pour être disposés dans un corps de carte par exemple, selon des techniques connues telles que la lamination, le moulage, etc..

La figure 5 est une vue schématique de dessus des étapes du dépôt de la protection selon le procédé de la présente invention.

Des puces de circuit intégré 10 sont collées sur un support 15 et connectées par des fils de connexion 17.

Un cordon de résine 35 est déposé selon une forme adaptée autour de chaque puce 10.

La composition des résines 30 et 35 permet en outre d'ajuster leurs propriétés mécaniques afin d'éviter les stress préjudiciables à la tenue et au fonctionnement des micromodules obtenus par le procédé.

Selon les variantes, le cordon de résine 35 peut éventuellement empiéter sur la puce 10 et/ou sur les fils de connexion 17.

En effet, la résine du cordon 35 remplie, outre sa fonction de limitation de l'étalement, une fonction de protection tout comme la résine de remplissage 30 ainsi qu'une fonction de rigidité et de stabilité du micromodule. Il est par conséquent avantageux que la résine du cordon 35 soit au plus proche de la puce 10 et de ses fils 17.

La résine de remplissage 30 vient ensuite remplir l'espace délimité par le cordon de résine 35. Les deux résines 30 et 35 se mélange légèrement sur leur périphérie.

L'exposition aux ultraviolets permet de polymériser les résines et d'obtenir ainsi une protection fine, étanche et reproductible.

La polymérisation des résines utilisées par exposition aux ultraviolets permet d'éviter une rupture dans la cadence de fabrication en supprimant le traditionnel séchage en étuve pendant de nombreuses heures des résines thermiques.

## Revendications

1. Procédé de protection d'un dispositif électronique portable à circuit intégré pourvu de connexions, par dépôt d'un cordon de résigne (35) de forte viscosité autour du circuit et de ses connexions, et d'une résine de remplissage (30) de faible viscosité relativement à celle du cordon, dans l'espace délimité par le cordon de résine (35) ;
Le procédé comportant les étapes suivantes réalisées à la suite et en continu :
- dépôt du cordon de résine (35) polymérisable aux ultraviolets, autour dé la puce (10) et de ses connexions (17), ledit cordon présentant une viscosité supérieure ou égale à 1500 poises ;
- dépôt de la résine de remplissage (30) polymérisable aux ultraviolets, dans un espace délimité par le cordon (35), ladite résine de remplissage présentant une viscosité inférieure ou égale à 60 poises et la résine de remplissage (30) comportant des fibres de renfort mécanique; et
- polymérisation simultanée des deux résines (30, 35) par exposition aux ultraviolets.

2. Procédé de fabrication selon la revendication 1, **caractérisé en ce que** les fibres de renfort sont des fibres de verre.

3. Procédé de fabrication selon la revendication 2, **caractérisé en ce que** les pourcentages de fibres de verre contenues dans les résines (30, 35) sont compris entre 5% et 20%.

4. Procédé de fabrication selon l'une quelconque des revendications précédentes, **caractérisé en ce que** les résines (30, 35) sont des résines époxydes cationiques.

5. Procédé de fabrication selon l'une quelconque des revendications précédentes, **caractérisé en ce que** les résines (30, 35) contiennent en outre un faible pourcentage d'ions fluorures extractibles, une partie desdits ions étant neutralisée par ajout de composés chimiques de Magnésium.

6. Procédé de fabrication selon la revendication 5, **caractérisé en ce que** les quantités d'ions fluorures contenues dans les résines (30, 35) sont comprises entre 20% et 40% des concentrations usuelles, ces dernières étant supérieures ou égales à 250 ppm.

7. Procédé de fabrication selon l'une quelconque des revendications précédentes, **caractérisé en ce que** les résines (30, 35) contiennent en outre des agents flexibilisants comprenant un ou le mélange de plusieurs alcools oligomériques.

8. Procédé de fabrication selon la revendication 7, **caractérisé en que** les alcools oligomériques sont des polyesters et/ou des polycarbonates et/ou des polybutadiènes et/ou les copolymères de ces derniers.

9. Procédé de fabrication selon l'une quelconque des revendications précédentes, **caractérisé en ce que** les résines (30, 35) contiennent en outre un ou le mélange de plusieurs photo initiateurs.

10. Procédé de fabrication selon la revendication 9, **caractérisé en ce que** les photos initiateurs sont des sels de triarylsulfonium.

11. Procédé de fabrication selon l'une quelconque des revendications précédentes, **caractérisé en ce que** les résines (30, 35) contiennent en outre des monomères et/ou des oligomères polymérisables par voie cationique sous ultraviolets.

12. Procédé de fabrication selon la revendication 11, **caractérisé en ce que** les monomères et/ou oligomères sont des époxydes cycloaliphahiques.

## Claims

1. A method for the protection of a portable integrated-circuit electronic device provided with connections, by depositing a strip of a high-viscous resin (35) about the circuit and the connections thereof, and a filling resin (30) with a low viscosity as compared to that of the strip, in the space defined by the resin (35) strip;
the method including the following steps executed in a sequence and continuously:
- the deposition of the strip of a resin (35) which can be polymerized under an ultraviolet radiation, about the chip (10) and the connections (17) thereof, said strip having a viscosity greater than or equal to 1,500 poises;
- the deposition of the filling resin (30) which can be polymerized under an ultraviolet radiation, in a space defined by the strip (35), with said filling resin having a viscosity lower than or equal to 60 poises and the filling resin (30) including mechanical reinforcement fibers; and
- the simultaneous polymerization of both resins (30, 35) by the exposure thereof to an ultraviolet radiation.

2. A production method according to claim 1, **characterized in that** the reinforcing fibers are glass fibers.

3. A production method according to claim 2, **characterized in that** the percentages of glass fibers contained in the resins (30, 35) are between 5% and 20%.

4. A production method according to any one of the preceding claims, **characterized in that** the resins (30, 35) are cationic epoxy resins.

5. A production method according to any one of the preceding claims, **characterized in that** the resins (30, 35) further contain a low percentage of extractable fluoride ions, with a part of said ions being neutralized by the addition of magnesium chemical compounds.

6. A production method according to claim 5, **characterized in that** the quantity of fluoride ions contained in the resins (30, 35) is between 20% and 40% of the usual concentration, with the latter being greater than or equal to 250ppm.

7. A production method according to any one of the preceding claims, **characterized in that** the resins (30, 35) further contain flexibilizing agents including a or the mixture of several oligomeric alcohols.

8. A production method according to claim 7, **characterized in that** the oligomeric alcohols are polyesters and/or polycarbonates and/or polybutadienes and/or copolymers thereof.

9. A production method according to any one of the preceding claims, **characterized in that** the resins (30, 35) further contain a or the mixture of several photo-initiators.

10. A production method according to claim 9, **characterized in that** the photo-initiators are triarylsulfonium salts.

11. A production method according to any one of the preceding claims, **characterized in that** the resins (30, 35) further contain monomers and/or oligomers which can be polymerized with cations under an ultraviolet radiation.

12. A production method according to claim 11, **characterized in that** the monomers and/or oligomers are cycloaliphatic epoxides.

## Patentansprüche

1. Verfahren zum Schutz einer mit Anschlüssen versehenen tragbaren elektronischen Vorrichtung mit integriertem Schaltkreis durch Aufbringen eines Harzwulstes (35) hoher Viskosität um die Schaltung und ihre Anschlüsse und eines Füllharzes (30) im Verhältnis zu derjenigen des Wulstes geringer Viskosität im vom Harzwulst (35) abgegrenzten Raum;
Wobei das Verfahren die nachstehenden Schritte umfaßt, die nacheinander und kontinuierlich ausgeführt werden:
- Aufbringen des mit Ultraviolettstrahlen polymerisierbaren Harzwulstes (35) um den Chip (10) und seine Anschlüsse (17), wobei der besagte Wulst eine Viskosität von über oder gleich 1.500 Poises aufweist;
- Aufbringen des mit Ultraviolettstrahlen polymerisierbaren Füllharzes (30) in einem vom Harzwulst (35) abgegrenzten Raum, wobei das besagte Füllharz eine Viskosität von unter oder gleich 60 Poises aufweist und das Füllharz (30) Fasern zur mechanischen Verstärkung enthält;
- Gleichzeitige Polymerisierung der beiden Harze (30, 35) durch Aussetzung den Ultraviolettstrahlen gegenüber.

2. Verfahren zur Fertigung nach Anspruch 1, **dadurch gekennzeichnet, daß** die Fasern zur Verstärkung Glasfasern sind.

3. Verfahren zur Fertigung nach Anspruch 2, **dadurch gekennzeichnet, daß** die in den Harzen (30, 35) enthaltenen Prozentsätze an Glasfasern bei zwischen 5% und 20% liegen.

4. Verfahren zur Fertigung nach einem beliebigen der vorstehenden Ansprüche, **dadurch gekennzeichnet, daß** die Harze (30, 35) kationische Epoxidharze sind.

5. Verfahren zur Fertigung nach einem beliebigen der vorstehenden Ansprüche, **dadurch gekennzeichnet, daß** die Harze (30, 35) ferner einen geringen Prozentsatz extrahierbarer Fluoridionen enthalten, wobei ein Teil der besagten Ionen durch Hinzufügung von chemischen Magnesiumkomponenten neutralisiert werden.

6. Verfahren zur Fertigung nach Anspruch 5, **dadurch gekennzeichnet, daß** die in den Harzen (30, 35) enthaltenen Mengen Fluoridionen bei zwischen 20% und 40% der üblichen Konzentrationen liegen, wobei diese letzteren bei über oder gleich 250 ppm gelegen haben.

7. Verfahren zur Fertigung nach einem beliebigen der vorstehenden Ansprüche, **dadurch gekennzeichnet, daß** die Harze (30, 35) ferner Flexibilisatoren enthalten, die eine oder die Mischung mehrerer oligomerischer Alkohole umfassen.

8. Verfahren zur Fertigung nach Anspruch 7, **dadurch gekennzeichnet, daß** die oligomerischen Alkohole Polyester und/oder Polykarbonate und/oder Polybutadiene und/oder Copolymere der letzteren sind.

9. Verfahren zur Fertigung nach einem beliebigen der vorstehenden Ansprüche, **dadurch gekennzeichnet, daß** die Harze (30, 35) außerdem einen oder die Mischung mehrerer Lichtinitiatoren enthalten.

10. Verfahren zur Fertigung nach Anspruch 9, **dadurch gekennzeichnet, daß** die Lichtinitiatoren Triarylsulfoniumsalze sind.

11. Verfahren zur Fertigung nach einem beliebigen der vorstehenden Ansprüche, **dadurch gekennzeichnet, daß** die Harze (30, 35) außerdem auf kationischem Wege unter Ultraviolettstrahlen polymerisierbare Monomere und/oder Oligomere enthalten.

12. Verfahren zur Fertigung nach Anspruch 11, **dadurch gekennzeichnet, daß** die Monomere und/oder Oligomere cycloaliphatische Epoxyde sind.
